(19) **Europäisches Patentamt**
**European Patent Office**
**Office européen des brevets**

(11) **EP 1 744 459 A2**

(12) **EUROPEAN PATENT APPLICATION**

(43) Date of publication:
**17.01.2007 Bulletin 2007/03**

(51) Int Cl.:
*H03K 19/177* *(2006.01)*

(21) Application number: **06014238.7**

(22) Date of filing: **10.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **11.07.2005 US 698225 P**
**06.10.2005 US 244572**

(71) Applicant: **Altera Corporation**
**San Jose, CA 95134 (US)**

(72) Inventors:
• **Santurkar, Vikram**
**Fremont**
**CA 94539 (US)**
• **Thiruveedhula, Ravi**
**Santa Clara**
**CA 95051 (US)**

(74) Representative: **Appelt, Christian W.**
**Forrester & Boehmert**
**Pettenkoferstrasse 20-22**
**80336 München (DE)**

(54) **Apparatus and methods for low-power routing in programmable logic devices**

(57)   An interconnect circuit includes a driver circuit and a receiver circuit. The receiver circuit couples to the driver circuit. The driver circuit is configured to receive an input signal and to derive from the input signal a limited swing driver output signal. The receiver circuit is configured to derive from the limited swing driver output signal a limited swing receiver output signal.

EP 1 744 459 A2

## Description

### Cross-Reference to Related Applications

This patent application claims priority to U.S. Provisional Patent Application Serial No. 60/698,225, titled "Apparatus and Methods for Low-Power Routing in Programmable Logic Devices," attorney docket number ALTR:048PZ1, filed on July 11, 2005.

### Technical Field

The inventive concepts relate generally to routing and interconnect circuitry and associated methods in programmable logic devices (PLDs). More particularly, the invention concerns routing and interconnect circuitry with relatively low power consumption and associated methods.

### Background

Modem PLDs have increased, and continue to increase, in complexity. Typical PLDs contain several tens of millions of transistors. On the one hand, the increased complexity of the PLDs has resulted in improved performance levels and increased flexibility. On the other hand, PLDs' complexity and the large number of transistor has resulted in increased power consumption in the device.

As device dimensions decrease below 0.1 $\mu$, power consumption becomes a more critical concern. This trend will likely continue, as the complexity of PLDs increases. Increased power consumption in PLDs results in elevated power density levels that can adversely impact the reliability and practical utility of PLDs. A need therefore exists for reducing the power consumption of PLDs.

### Summary

The disclosed novel concepts relate to apparatus and methods for interconnect circuits. One may use the interconnect circuits in PLDs, for example, to couple to one another the resources of the PLD, such as programmable logic circuits, etc.

In one embodiment, an interconnect circuit includes a driver circuit and a receiver circuit. The receiver circuit couples to the driver circuit. The driver circuit is configured to receive an input signal and to derive from the input signal a limited swing driver output signal. The receiver circuit is configured to derive from the limited swing driver output signal a limited swing receiver output signal.

In another embodiment, an interconnect circuit couples resources in a PLD. The interconnect circuit includes a driver circuit. The driver circuit has at least one transistor with a threshold voltage higher than a nominal threshold voltage within the PLD.

In yet another embodiment, a method of interconnecting circuitry within a PLD includes receiving in a circuit an input signal from a source, generating a limited swing output signal, and supplying the output signal to another circuit (a receiving circuit). The receiving circuit further generates a limited swing output signal.

### Brief Description of the Drawings

The appended drawings illustrate only exemplary embodiments of the invention and therefore should not be considered or construed as limiting its scope. Persons of ordinary skill in the art who have the benefit of the description of the invention appreciate that the disclosed inventive concepts lend themselves to other equally effective embodiments. In the drawings, the same numeral designators used in more than one drawing denote the same, similar, or equivalent functionality, components, or blocks.

FIG. 1 shows a general block diagram of a PLD according to an illustrative embodiment of the invention.

FIG. 2 illustrates a floor-plan of a PLD according to an exemplary embodiment of the invention.

FIG. 3 depicts a circuit arrangement that illustrates the routing function of an interconnect.

FIG. 4 shows a circuit arrangement for analyzing a first-order model of an interconnect circuit.

FIG. 5 illustrates a graph of power dissipation ($P$) as a function of voltage ($V$).

FIG. 6 depicts a circuit arrangement of an illustrative embodiment of an interconnect according to the invention.

FIGs. 7 shows a circuit arrangement of another illustrative embodiment of an interconnect according to the invention.

FIGs. 8 and 10-13 illustrate circuit arrangements of various exemplary embodiments of interconnects according to the invention.

FIG. 9 depicts plots of a signal used during power-up in exemplary embodiments according to the invention.

**Detailed Description**

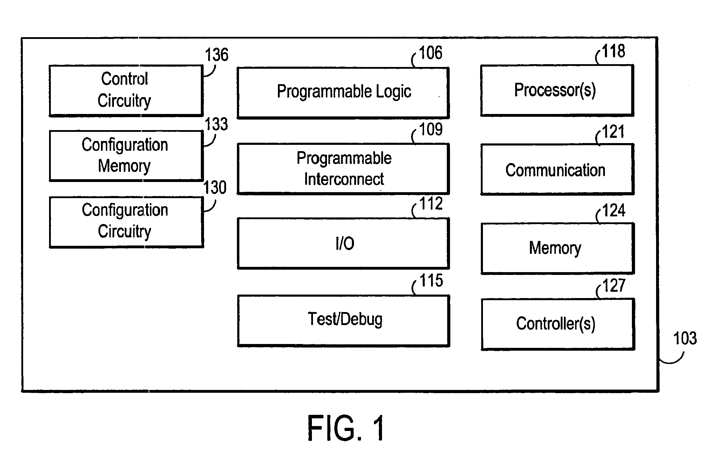

The inventive concepts contemplate apparatus and associated methods for reducing power consumption within PLDs. FIG. 1 shows a general block diagram of a PLD 103 according to an illustrative embodiment of the invention. PLD 103 includes configuration circuitry 130, configuration memory (CRAM) 133, control circuitry 136, programmable logic 106, programmable interconnect 109, and I/O circuitry 112. In addition, PLD 103 may include test/debug circuitry 115, one or more processors 118, one or more communication circuitry 121, one or more memories 124, one or more controllers 127, as desired.

Programmable logic 106 includes blocks of configurable or programmable logic circuitry, such as look-up tables (LUTs), product-term logic, multiplexers (MUXs), logic gates, registers, memory, and the like. Programmable interconnect 109 couples to programmable logic 106 and to other blocks and circuitry within PLD 103, as desired. As described below in detail, programmable interconnect 109 provides configurable interconnects (coupling mechanisms) between various blocks within programmable logic 106 and other circuitry within or outside PLD 103.

Control circuitry 136 controls various operations within PLD 103. Under the supervision of control circuitry 136, PLD configuration circuitry 130 uses configuration data (which it obtains from an external source, such as a storage device, a host, etc.) to program or configure the functionality of PLD 103. Configuration data are typically used to store information in CRAM 133. The contents of CRAM 133 determine the functionality of various blocks of PLD 103, such as programmable logic 106 and programmable interconnect 109.

I/O circuitry 112 may constitute a wide variety of I/O devices or circuits, as persons of ordinary skill in the art who have the benefit of the description of the invention understand. I/O circuitry 112 may couple to various parts of PLD 103, for example, programmable logic 106 and programmable interconnect 109. I/O circuitry 112 provides a mechanism and circuitry for various blocks within PLD 103 to communicate with external circuitry or devices.

Test/debug circuitry 115 facilitates the testing and troubleshooting of various blocks and circuits within PLD 103. Test/debug circuitry 115 may include a variety of blocks or circuits known to persons of ordinary skill in the art who have the benefit of the description of the invention. For example, test/debug circuitry 115 may include circuits for performing tests after PLD 103 powers up or resets, as desired. Test/debug circuitry 115 may also include coding and parity circuits, as desired.

PLD 103 may include one or more processors 118. Processor 118 may couple to other blocks and circuits within PLD 103. Processor 118 may receive data and information from circuits within or external to PLD 103 and process the information in a wide variety of ways, as persons skilled in the art with the benefit of the description of the invention appreciate. One or more of processor(s) 118 may constitute a digital signal processor (DSP). DSPs allow performing a wide variety of signal processing tasks, such as compression, decompression, audio processing, video processing, filtering, and the like, as desired. As persons of ordinary skill in the art who have the benefit of the description of the invention understand, rather than using a dedicated DSP, one may use the logic resources of PLD 103 to implement DSP functionality, as desired.

PLD 103 may also include one or more communication circuits 121. Communication circuit(s) 121 may facilitate data and information exchange between various circuits within PLD 103 and circuits external to PLD 103, as persons of ordinary skill in the art who have the benefit of the description of the invention understand.

PLD 103 may further include one or more memories 124 and one or more controller(s) 127. Memory 124 allows the storage of various data and information (such as user-data, intermediate results, calculation results, etc.) within PLD 103. Memory 124 may have a granular or block form, as desired. Controller 127 allows interfacing to, and controlling the operation and various functions of circuitry outside the PLD. For example, controller 127 may constitute a memory controller that interfaces to and controls an external synchronous dynamic random access memory (SDRAM), as desired.

Note that FIG. 1 shows a simplified block diagram of PLD 103. Thus, PLD 103 may include other blocks and circuitry, as persons of ordinary skill in the art understand. Examples of such circuitry include clock generation and distribution circuits, redundancy circuits, and the like. Furthermore, PLD 103 may include, analog circuitry, other digital circuitry, and/or mixed-mode circuitry, as desired.

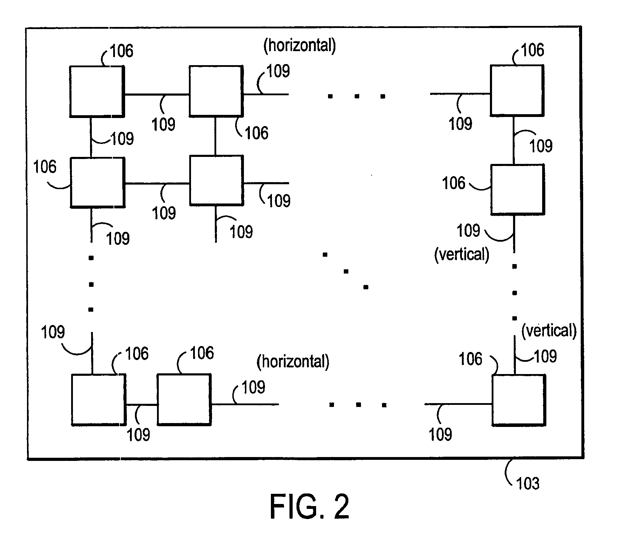

FIG. 2 shows a floor-plan of a PLD 103 according to an exemplary embodiment of the invention. PLD 103 includes programmable logic 106 arranged as a two-dimensional array. Programmable interconnect 109, arranged as horizontal interconnect and vertical interconnect, couples the blocks of programmable logic 106 to one another. In illustrative embodiments, PLDs according to the invention may have a hierarchical architecture. In other words, each block of programmable logic 106 may in turn include smaller or more granular programmable logic blocks or circuits.

Programmable interconnect 109 provides a mechanism for various blocks of PLD 103 (see FIG. 1) to communicate with one another. Generally speaking, the configuration data (or programming data) of PLD 103 determines the functionality realized by its resources, including programmable logic 106 and programmable interconnect 109. Using configurable blocks of circuit, such as multiplexers, transmission gates, and pass transistors, programmable interconnect 109 can route signals among various circuits in PLD 103.

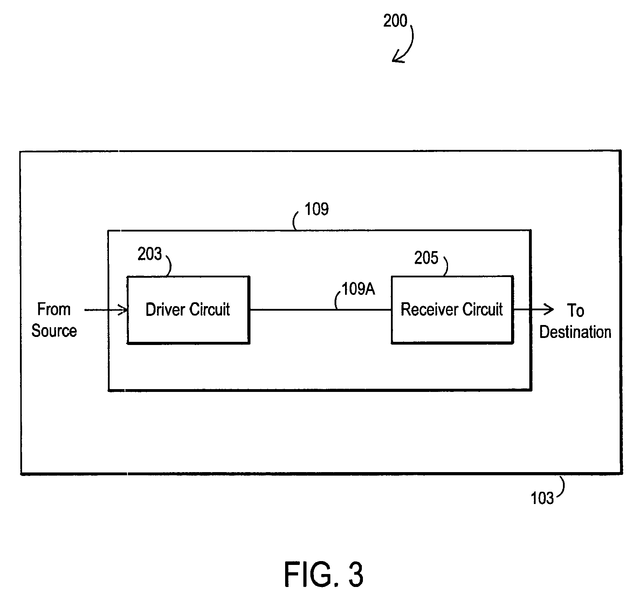

FIG. 3 shows a circuit arrangement 200 that illustrates the routing function of an interconnect 109. Interconnect 109 includes a driver circuit 203, and a receiver circuit 205 that communicate via a coupling mechanism 109A. As persons of ordinary skill in the art who have the benefit of the description of the invention understand, coupling mechanism 109A may take a variety of forms, as desired. The choice of the specific implementation depends on a number of factors, such as the desired application, design and performance specifications, etc. By way of examples, coupling mechanism may include a conductor, wire, or conductor traces on PLD 103, interconnect, etc., as desired.

Each of driver circuit 203 and receiver circuit 205 may communicate with a source and destination block, respectively, in PLD 103 (see FIG. 1), such as programmable logic 106, processor 118, memory 124, etc. In other words, driver circuit 203 receives signal(s) from a source in PLD 103 and communicates the signal(s) to receiver circuit 205 via coupling mechanism 109A. Receiver circuit 205 provides the signal(s) received from coupling mechanism 109A to a destination in PLD 103.

Because it spans PLD 103 (either in one segment or in smaller, interconnected segments), interconnect 109 often includes a large number of electronic components, such as metal oxide semiconductor field effect transistors (MOSFETs). The operation of the transistors can give rise to relatively large power dissipation within PLD 103. More specifically, the operation of the transistors can give rise to static power dissipation (typically resulting from leakage) and dynamic power dissipation (typically resulting from the switching of the transistors), as persons of ordinary skill in the art who have the benefit of the description of the invention understand.

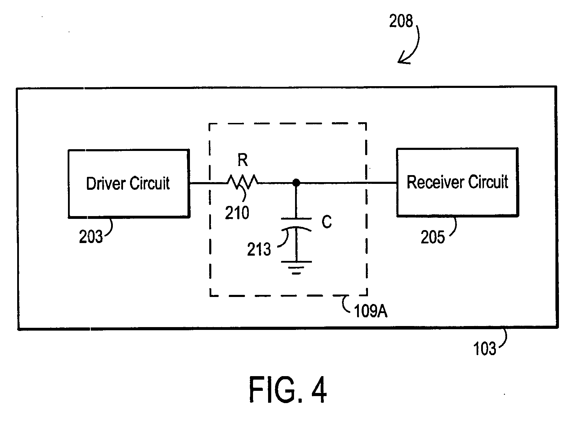

FIG. 4 shows a circuit arrangement 208 that facilitates analysis of a first-order model of interconnect 109. Circuit arrangement 208 models interconnect 109A as a resistor-capacitor network that includes resistor 210 and capacitor 213. Resistor 210 may include the output resistance of driver circuit 203 and the resistance of coupling mechanism 109A. Capacitor 213 may include the capacitance of coupling mechanism 109A and the input capacitance of receiver circuit 205.

Assuming resistor 210 to have a negligible value (i.e., a relatively strong buffer within driver circuit 203, low-resistance coupling mechanism 109A, etc.), one may model power dissipation of driver circuit 203. Given that the signals communicated via coupling mechanism 109A switch at a frequency $f$, the power dissipation $P$ has a value:

$$P = C\,V^2 f,$$

where $C$ and $V$ represent the capacitance of capacitor 213 and the output voltage of driver circuit 203, respectively. Note that the above equation assumes complementary circuitry at the output of driver circuit 203 (i.e., voltage swings between a ground voltage and $V$). Receiver circuit 205 typically has circuitry similar to driver circuit 203 and thus experiences power dissipation as a result of the switching signal(s).

Note that, as the above equation shows, switching power dissipation increases as $C$, $V$, and/or $f$ increase. The physical attributes of coupling mechanism 109A, often dictated by the layout of PLD 103 to accomplish signal communication and distribution, determine the value of capacitance $C$ (designers seeks to reduce $C$ as much as practicable). Similarly, the value of frequency $f$ depends on the functionality that the PLD's user seeks to implement.

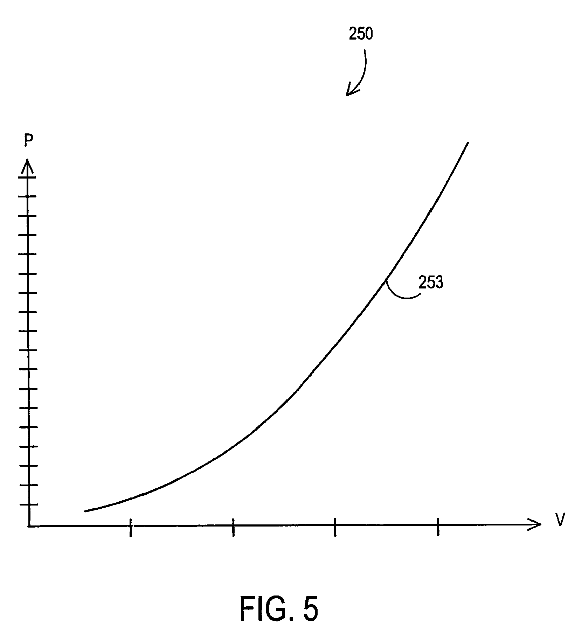

One may, however, influence the power dissipation in interconnect 109 by decreasing the value of $V$. Note that power P increases as the square of voltage $V$, as the graph 250 of power dissipation ($P$) versus voltage ($V$) in FIG. 5 illustrates. Thus, decreasing $V$ has a more pronounced effect on power dissipation than does a similar decrease in $C$ or $f$.

In conventional interconnects, the signals have a swing between ground and the supply voltage ($V_{DD}$). As described below in detail, the inventive concepts in part contemplate apparatus and corresponding methods for reducing the voltage swing to values above ground and below the supply voltage ($V_{DD}$). Put another way, interconnects according to the invention use voltage swings with lower ($V_L$) and upper ($V_H$) values, respectively, of:

$$V_L = V_{GND} + \Delta_1,$$

and

$$V_H = V_{DD} - \Delta_2,$$

where $\Delta_1$ and $\Delta_2$ denote values that depend on the particular circuit topology and design used.

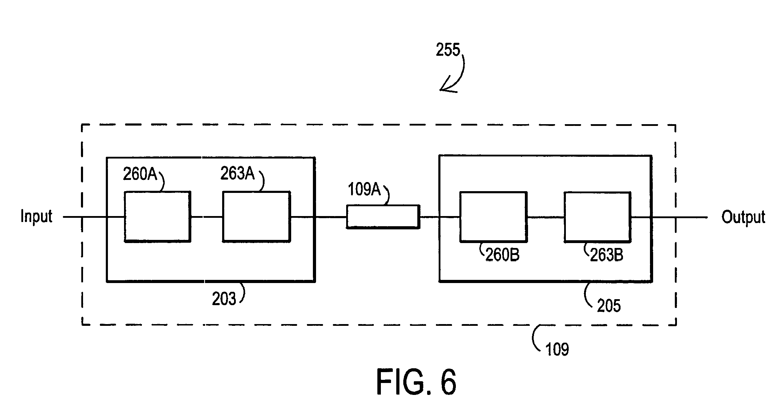

FIG. 6 shows a circuit arrangement 255 of an illustrative embodiment of an interconnect 109 according to the invention. Driver circuit 203 in circuit arrangement 255 includes two stages, a pre-driver circuit or conditioning circuit 260A (first stage) and a level converter circuit 263A (second stage). Pre-driver circuit 260A drives level converter 263. Level converter 263A couples to coupling mechanism 109A and supplies signal(s) derived from one or more input signals to coupling mechanism 109A. The signal(s) supplied to coupling mechanism 109A have a reduced voltage swing.

Coupling mechanism 109A provides the signal(s) received from driver circuit 203 to receiver circuit 205. Receiver circuit 205 includes a pre-driver circuit or conditioning circuit 260B as its first stage. Pre-driver circuit 260B may have a similar circuit arrangement and topology as pre-driver circuit 260A, as desired. Pre-driver circuit 260B derives one or more signals from signal(s) it receives from coupling mechanism 109A. Pre-driver circuit 260B provides those signal(s) to level converter circuit 263B. Level converter circuit 263B provides a low-swing signal as an output signal of interconnect 109. Level converter circuit 263B may have a similar circuit arrangement and topology as level converter 263A, as desired.

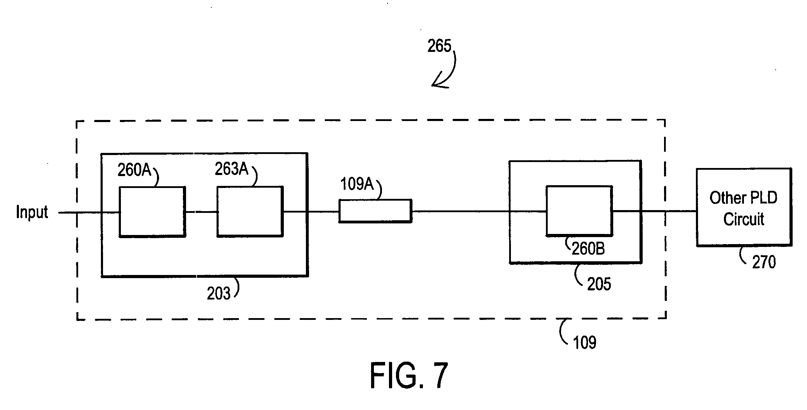

FIG. 7 shows a circuit arrangement 265 of another illustrative embodiment of an interconnect 109 according to the invention. Unlike the circuit arrangement in FIG. 6, circuit arrangement 265 provides normal- or regular-swing logic signals (e.g., signals with a rail to rail, or $V_{DD}$ to ground, voltage swing) as its output.

More specifically, driver circuit 203 in circuit arrangement 255 includes two stages, a pre-driver circuit or conditioning circuit 260A (first stage) and a level converter circuit 263A (second stage). Pre-driver circuit 260A drives level converter 263. Level converter 263A couples to coupling mechanism 109A and supplies signal(s) derived from one or more input signals to coupling mechanism 109A. The signal(s) supplied to coupling mechanism 109A have a reduced voltage swing.

Coupling mechanism 109A provides the signal(s) received from driver circuit 203 to receiver circuit 205. Receiver circuit 205 includes a pre-driver circuit or conditioning circuit 260B as its first stage. Pre-driver circuit 260B may have a similar circuit arrangement and topology as pre-driver circuit 260A, as desired. Pre-driver circuit 260B derives one or more signals from signal(s) it receives from coupling mechanism 109A and provides the signal(s) at its output. Pre-driver circuit 260B couples to, and drives, PLD circuit 270. PLD circuit 270 accepts normal-swing logic signals at its input(s).

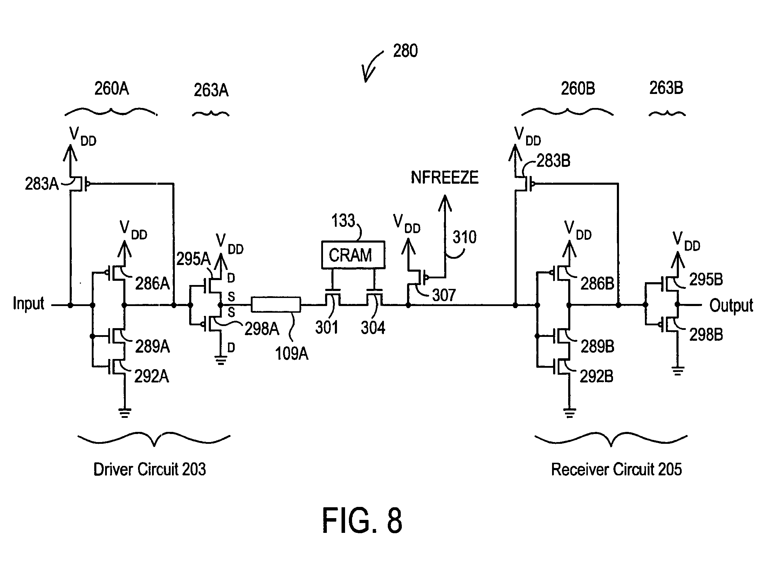

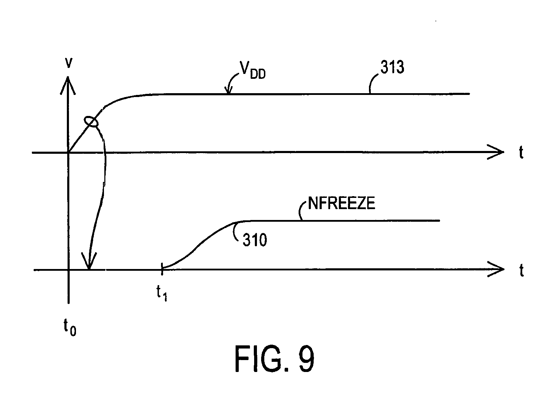

FIGs. 8 and 10-13 provide circuit arrangements for illustrative embodiments of interconnect circuitry, including low power consumption drivers and associated circuitry, according to the invention. FIG. 9 shows plots of certain signals used in some embodiments, as described below in detail.

Note that each of the embodiments in FIGs. 8 and 10-13 includes driver circuit 203 and receiver circuit 205. Each driver circuit 203 (e.g., 203A/203B) includes pre-driver circuit 260 (e.g., 260A/260B) and level converter circuit 263 (e.g., 263A/263B). Level converters 263A and 263B are similar in FIGs. 8 and 10-13, and operate similarly. Furthermore, the embodiments in FIGs. 8 and 10-13 include similar arrangements of transistors 301, 304, and 307, with associated circuitry for driving the gates of those transistors, which operate in a like manner.

Referring to circuit arrangement 280 in FIG. 8, pre-driver circuit 260A includes transistors 283A, 286A, 289A, and 292A. Level converter 263A includes transistors 295A and 298A. Transistors 286A and 289A form an inverter, as persons of ordinary skill in the art who have the benefit of the description of the invention understand. Transistor 292A couples in series with transistor 289A (and uses the same gate signal, i.e., the input signal in circuit arrangement 280).

Transistor 292A has a relatively high threshold voltage ($V_T$), i.e., a higher than nominal threshold voltage, sometimes called a high-$V_T$ (HVT) transistor. For example, transistor 292A may have a threshold voltage that deviates from the nominal threshold voltage for the particular fabrication process by +80 mV.

The combination of transistor 289A, with a nominal threshold voltage, and transistor 292A, with a relatively high threshold voltage, allows pre-driver circuit 260A to recognize a non-zero input voltage as a logic low signal. For example, pre-driver circuit 260A can recognize a voltage having the value of roughly $V_{TP}$ (nominal threshold voltage of a PMOS transistor) as a logic low signal. In the absence of transistor 292A, transistor 289A may fail to turn off when the input voltage has a value of $V_{TP}$ (or approximately $V_{TP}$).

Furthermore, the relatively high threshold voltage of transistor 292A helps to prevent it from turning on and thus leaking current that would result in increased power dissipation (i.e., it reduces the crow-bar current). Put another way, the relatively high threshold voltage helps to reduce the leakage current in the series combination of transistor 289A and 292A, thus reducing the leakage current of the inverter. Transistor 283A acts as a pull-up device and, using regenerative feedback, restores logic high input signals.

More specifically, a logic high input may have a lower than nominal voltage (e.g., because of coupling through MUXs or pass transistors). The regenerative action of transistor 283A restores that voltage a logic high signal ($V_{DD}$). The combination of the inverter and transistor 283A forms a half-latch, as persons of ordinary skill in the art who have the benefit of the description of the invention understand.

The output of the inverter drives level converter 263A. Level converter 263A includes transistor 295A and transistor 298A, coupled in series. Level converter 263A has a similar topology to an inverter, except with the PMOS and NMOS devices interchanged (i.e., the PMOS device occupies the lower stack and the NMOS device constitutes the upper stack). Because of this topology, the output of level converter 263A has a reduced voltage swing.

More specifically, the output voltage of level converter 263A has a voltage swing between ($V_{GND}$ + $V_{TP}$) and

($V_{DD}$ - $V_{TN}$), where $V_{TP}$ and $V_{TN}$ denote the threshold voltages of transistor 298A and 295A, respectively. Thus, level converter 263A has a lower voltage swing than a typical CMOS circuit (i.e., between $V_{GND}$ and $V_{DD}$). The reduced voltage swing help to reduce power consumption, as described above.

Pre-driver circuit 260B includes transistors 283B, 286B, 289B, and 292B. Level converter 263B includes transistors 295B and 298B. Pre-driver circuit 260B and level converter 263B operate similarly to pre-driver circuit 260A and level converter 263A, respectively. According to simulation results, in one embodiment, circuit arrangement 280 can provide 29% power savings over conventional approaches.

Coupling mechanism 109A and transistors 301 and 304 couple level converter 263A to pre-driver 260B. Memory cells in CRAM 133 drive the gates of transistors 301 and 304. Thus, effectively, transistors 301 and 304 act as pass transistors. Depending on the data in the memory cells of CRAM 133, transistors 301 and 304 can selectively couple level converter 263A to pre-driver 260B. Note that one may use a different number or arrangement of transistors and memory cells, as desired, and as persons of ordinary skill in the art who have the benefit of the description of the invention understand.

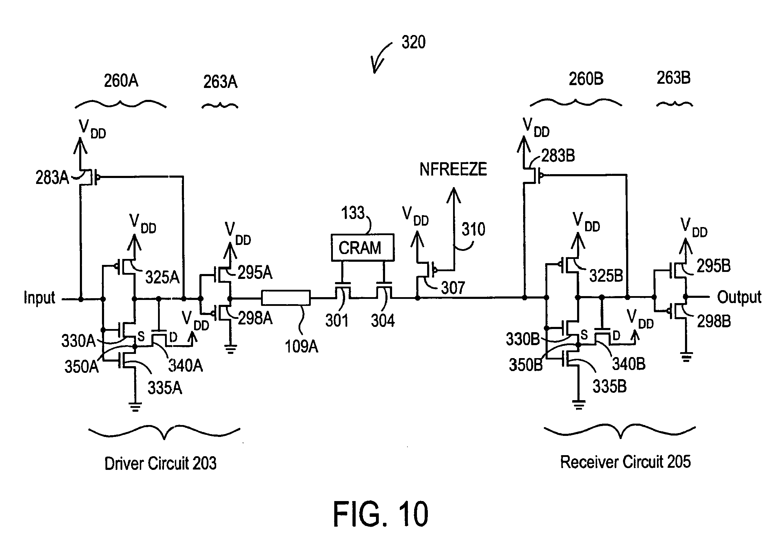

Transistor 307 acts as a pull-up transistor. In the situation where both transistors 301 and 304 are OFF, transistor 307 can pull up the input of pre-driver 260B to near the supply voltage and, hence, prevent the input from floating or having an indeterminate value. Signal *NFREEZE* drives the gate of transistor 307. Note that the embodiments in FIGs. 10-13 use a similar circuit arrangement.

FIG. 9 shows a plot of the timing of signal *NFREEZE* with respect to the supply voltage at the initial powering up of PLD 103. At $t = t_0$, supply voltage 313 begins to ramp up to its final value, $V_{DD}$. Subsequent to $t_0$, at $t = t_1$, signal 310 (*NFREEZE*) begins to ramp up to a final value near $V_{DD}$. Between $t = t_0$ and $t = t_1$, however, signal 310 has a logic low value. As a result, transistor 307 turns ON and raises the input of pre-driver 263B to near $V_{DD}$, or a logic high value. Note that one may use a variety of other timing and signal arrangements than those shown in FIG. 9, as desired, and as persons of ordinary skill in the art who have the benefit of the description of the invention understand.

FIG. 10 shows a circuit arrangement 320 for use in illustrative embodiments of interconnect circuitry, including low power consumption drivers and associated circuitry, according to the invention. Circuit arrangement 320 includes driver circuit 203 and receiver circuit 205. Driver circuit 203 includes pre-driver circuit 260A and level converter 263A. Receiver circuit 205 includes pre-driver circuit 260B and level converter 263B. Pre-driver circuits 260A and 260B have a similar topology and operate in a like manner. Likewise, level converters 263A and 263B have a similar topology and operate similarly.

Pre-driver circuit 260A includes transistors 283A, 325A, 330A, 335A, and 340A. Transistors 283A, 325A, 330A, and 335A form a circuit similar to pre-driver 260A of FIG. 8. Thus, transistor 335A has a relatively high $V_T$(HVT), i.e., higher than a nominal threshold voltage, which results in decreased power consumption, as described above. Pre-driver 260A in FIG. 10, however, includes an additional transistor 340A.

Transistor 340A has its drain terminal coupled to $V_{DD}$. Transistor 340A presets node 350A (i.e., the node between transistor 330A and HVT transistor 335A) to ($V_{DD}$ - $V_{TN}$) during a low input transition (in a sense, transistor 340A acts as a Schmitt trigger). In other words, transistor 340A holds node 350 at ($V_{DD}$ - $V_{TN}$) when the input has a logic low state (input to the circuit has a value of $V_{TP}$). With a logic low input, transistor 340A causes transistor 330A to have a higher source voltage. The high source voltage causes transistor 330A to have a higher threshold voltage and, hence, less static power consumption.

More specifically, the threshold voltage, VT, of transistor 340A depends on a number of factors, such as the voltage between its source and body. The following equation provides the threshold voltage as a function of the body-to-source voltage:

$$V_T = V_{T(0)} + \gamma \left\{ \sqrt{2\phi_F - v_{BS}} - \sqrt{2\phi_F} \right\}. \tag{1}$$

Alternatively, one may write Equation 1 in terms of the source-to-body voltage:

$$V_T = V_{T(0)} + \gamma \left\{ \sqrt{2\phi_F + v_{SB}} - \sqrt{2\phi_F} \right\}, \tag{2}$$

where

$V_{T(0)}$ = the threshold voltage with the source-to-body voltage (or body-to-source voltage) set to zero;

$\gamma$ = the body factor, a constant that depends on the doping levels of the body;

$\phi_F$ = a constant;

$v_{BS}$ = the total body-to-source voltage (*i.e.,* including AC and DC components);

and

$v_{SB}$ = the total source-to-body voltage (*i.e.,* including AC and DC components).

Note that when the body-to-source voltage, $v_{BS}$ (or source-to-body voltage, $v_{SB}$) equals zero, the threshold voltage, $V_T$, equals $V_{T(o)}$. As Equation 2 shows, for a finite body factor, $\gamma$, the transistor's threshold voltage increases as the source-to-body voltage, $v_{SB}$, increases. The increase in the threshold voltage decreases the leakage current and, hence, the static power consumption. Thus, by raising the source voltage of transistor 330A and, hence, its source-to-body voltage, $v_{SB}$, transistor 340A decreases power consumption of pre-driver circuit 260A. According to simulation results, in one embodiment, circuit arrangement 280 can provide 35% power savings over conventional approaches.

Pre-driver circuit 260B includes transistors 325, 330B, 335B, and 340B. Level converter 263B includes transistors 295B and 298B. Pre-driver circuit 260B and level converter 263B operate similarly to pre-driver circuit 260A and level converter 263A, respectively. According to simulation results, in one embodiment, circuit arrangement 280 can provide 35% power savings over conventional approaches.

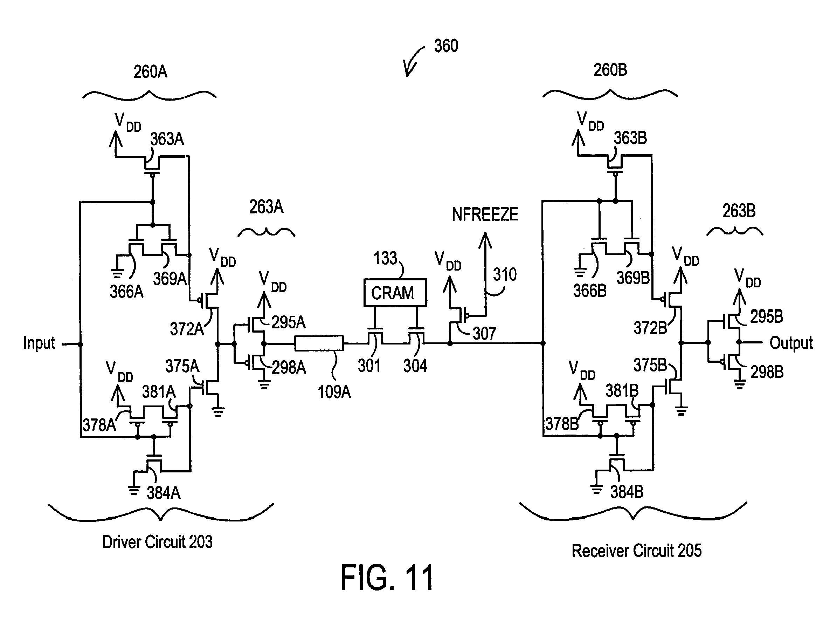

FIG. 11 shows a circuit arrangement 360 for use in illustrative embodiments of interconnect circuitry, including low power consumption drivers and associated circuitry, according to the invention. Circuit arrangement 360 includes driver circuit 203 and receiver circuit 205. Driver circuit 203 includes pre-driver circuit 260A and level converter 263A. Receiver circuit 205 includes pre-driver circuit 260B and level converter 263B. Pre-driver circuits 260A and 260B have a similar topology and operate in a like manner. Likewise, level converters 263A and 263B have a similar topology and operate similarly.

Pre-driver circuit 260A includes transistors 363A-384A. Transistors 372A and 375A couple in a series stack, driven by complementary signals. Unlike the pre-driver circuits described in previous figures, pre-driver 260A does not include a half-latch. Instead, separate circuits drive the gates of transistors 372A and 375A with complementary gate signals.

More specifically, transistors 363A, 366A, and 369A drive the gate of PMOS transistor 372A. The circuit driving transistors 372A includes a series stack of NMOS transistors (i.e., transistors 366A and 369A). Conversely, transistors 384A, 378A, and 381A drive the gate of NMOS transistor 375A. The circuit driving transistor 375A includes a series stack of PMOS transistors (i.e., transistors 378A and 381A). This arrangement of the circuits driving transistors 372A and 375A reduces the crow-bar current through pre-driver circuit 260A.

Pre-driver circuit 260A operates as follows: If the input signal has a logic high signal ($V_{DD}$ - $V_{TN}$), transistor 363A is OFF, while transistors 366A and 369A are ON. The logic high input signals also causes transistors 378A and 381A to be OFF, and transistor 384A to be ON, pulling the gate of transistor 375A towards circuit ground. As a result, transistor 375A is OFF, and transistor 372A is ON, supplying a logic high signal to level converter 263A.

Conversely, if the input signal has a logic low signal ($V_{Tp}$), transistor 363A is ON, while transistors 366A and 369A are OFF. The logic low input signal also turns ON transistors 378A and 381A, pulling the gate of transistor 375A high, and also turns OFF transistor 384A. As a result, transistor 375B is OFF, and transistor 375A is OFF, supplying a logic low signal to level converter 263A.

Pre-driver circuit 260B includes transistors 363B-384B, arranged similarly to pre-driver circuit 260A. Level converter 263B includes transistors 295B and 298B. Pre-driver circuit 260B and level converter 263B operate similarly to pre-driver circuit 260A and level converter 263A, respectively. According to simulation results, in one embodiment, circuit arrangement 320 can provide 20% power savings over conventional approaches.

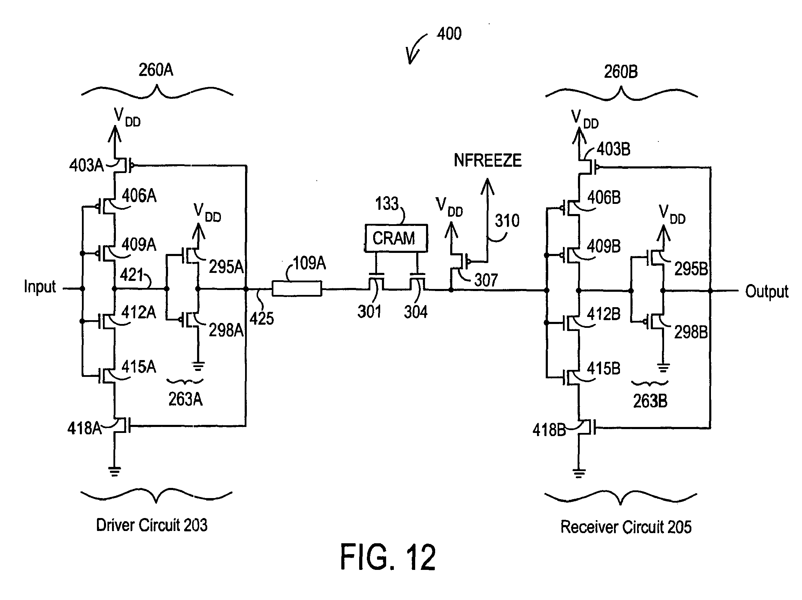

FIG. 12 shows a circuit arrangement 400 for use in illustrative embodiments of interconnect circuitry, including low power consumption drivers and associated circuitry, according to the invention. Circuit arrangement 400 includes driver circuit 203 and receiver circuit 205. Driver circuit 203 includes pre-driver circuit 260A and level converter 263A. Receiver circuit 205 includes pre-driver circuit 260B and level converter 263B. Pre-driver circuits 260A and 260B have a similar topology and operate in a like manner. Likewise, level converters 263A and 263B have a similar topology and operate similarly.

Pre-driver circuit 260A includes transistors 403A, 406A, 409A, 412A, 415A, and 418A. Transistors 403A and 418A provide a feedback mechanism for driver circuit 203. Transistors 406A and 409A couple to form a series PMOS stack. Conversely, transistors 412A and 415A couple together to form a series NMOS stack. The input signal couples to, and drives, both the PMOS stack (i.e., the gates of transistors 406A and 409A) and the NMOS stack (i.e., the gates of transistors 412A and 415A).

Including the PMOS and NMOS stacks and feedback transistors 403A and 418A in driver circuit 203 reduces crow-bar currents in pre-driver 260A, similar to the corresponding circuit in FIG. 11. Unlike the circuit in FIG. 11, however, circuit arrangement 400 uses feedback (via transistors 403A and 418A) to do so. Furthermore, the PMOS and NMOS stacks reduce or tend to reduce the static leakage current. As a result, the power consumption of circuit arrangement 400 is less than conventional circuits.

Pre-driver circuit 260A operates as follows: Suppose that the output signal of pre-driver circuit 260A (i.e., node 425) has a logic low value ($V_{TP}$), and the input signal makes a transition to a logic low value. As a result, transistors 406A and 409A turn ON, while transistors 412A and 415A turn OFF. Consequently, the PMOS stack (transistors 406A and 409A) pull node 421 high ($V_{DD}$ - $V_{TN}$).

Because of the feedback mechanism, when the input makes it transition to a low signal, transistor 403A turns OFF almost completely. Also because of the feedback mechanism, transistor 418A turns ON almost completely. The converse events occur for opposite input values, as persons of ordinary skill in the art who have the benefit of the description of the invention understand.

Pre-driver circuit 260B includes transistors 403B, 406B, 409B, 412B, 415B, and 418B. Level converter 263B includes transistors 295B and 298B. Pre-driver circuit 260B and level converter 263B operate similarly to pre-driver circuit 260A and level converter 263A, respectively. According to simulation results, in one embodiment, circuit arrangement 400 can provide 42% power savings over conventional approaches.

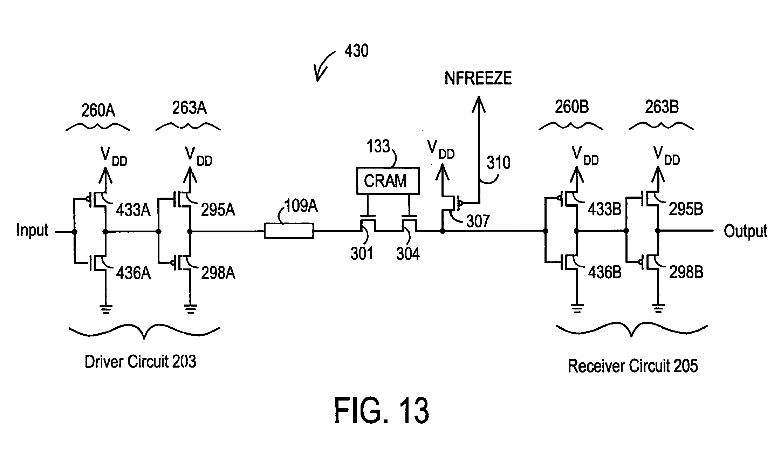

FIG. 13 shows a circuit arrangement 430 for use in illustrative embodiments of interconnect circuitry, including low power consumption drivers and associated circuitry, according to the invention. Circuit arrangement 430 includes driver circuit 203 and receiver circuit 205. Driver circuit 203 includes pre-driver circuit 260A and level converter 263A. Receiver circuit 205 includes pre-driver circuit 260B and level converter 263B. Pre-driver circuits 260A and 260B have a similar topology and operate in a like manner. Likewise, level converters 263A and 263B have a similar topology and operate similarly.

Pre-driver circuit 260A includes PMOS transistor 433A and NMOS transistor 436A. Transistors 433A and 436A couple together as an inverter, as known to persons of ordinary skill in the art. Unlike an ordinary inverter, however, transistors 433A and 436A have relatively high threshold voltages ($V_T$), i.e., higher than a nominal threshold voltage, sometimes called super-high-$V_T$ (SHVT) transistors. For example, transistor 433A or 436A may have a threshold voltage that deviates from the nominal threshold voltage for the particular fabrication process by 80 mV.

Use of transistors 433A and 436A, with relatively high threshold voltages, reduces crow-bar currents in pre-driver circuit 260A. More specifically, suppose that the input has a logic high value ($V_{DD}$ - $V_{TN}$). An ordinary PMOS transistor, with a nominal threshold voltage, might turn ON and conduct some current, thus resulting in a relatively high crow-bar current.

If the input has a logic low value (VTP), however, an ordinary NMOS transistor, with a nominal threshold voltage, might turn ON and conduct a finite amount of current that results in an elevated crow-bar current. Using transistors 433A and 436A, with higher absolute threshold voltages (e.g., SHVT), however, avoids those situations. Put another way, the relatively high threshold voltage of transistor 433A prevents it from turning ON in the presence of a logic low input. Conversely, the relatively high threshold voltage of transistor 4338 prevents it from turning ON when the input signal has a logic high value.

Level converter 263A includes transistors 295A and 298A. Transistors 295A and 298A have a relatively low threshold voltage, sometimes called low threshold voltage (LVT). For example, transistor 295A or 298A may have a threshold voltage that deviates from the nominal threshold voltage for the particular fabrication process by -80 mV. The relatively low threshold voltages of transistors 295A and 298A ensure reliable and enhanced operation of level converter 263A.

More specifically, transistors 295A and 298A having relatively low threshold voltages (LVT) results in reduced swing output signals, i.e., logic high level of $V_{DD}$-$V_{TN(LVT)}$ and logic low level of $V_{GND}$ + $V_{TP(LVT)}$, where $V_{TN(LVT)}$ and $V_{TP(LVT)}$ denote the relatively low threshold voltages (LVT). Because pre-driver circuit 260B uses transistors 433B and 436B with higher absolute threshold voltages (SHVT), the applied logic high and low levels ensure that the transistors in pre-driver circuits 260B are completely "OFF."

In other words, the circuit relies on the difference in the threshold voltages of the transistors in the second stage of driver circuit 203 and the transistors in the first stage of receiver circuit 205 to ensure proper operation without (or with relatively low) quiescent static leakage current. In addition, the relatively low threshold voltages result in increased current drive capability of transistors 295A and 298A (and, similarly, transistors 295B and 298B), thus increasing their operating speeds.

Pre-driver circuit 260B includes PMOS transistor 433B and NMOS transistor 436B. Transistors 433B and 436B have characteristics similar to transistors 433A and 436A, respectively. Level converter 263B includes transistors 295B and 298B. Pre-driver circuit 260B and level converter 263B operate similarly to pre-driver circuit 260A and level converter 263A, respectively. Transistors 295B and 298B have characteristics similar to transistors 295A and 298A, respectively. According to simulation results, in one embodiment, circuit arrangement 430 can provide 42% power savings over conventional approaches.

Note that one may apply the inventive concepts effectively to various programmable integrated circuits (ICs) that include programmable or configurable logic circuitry, known by other names in the art, as desired, and as persons skilled in the art with the benefit of the description of the invention understand. Such circuitry include, for example, devices known as complex programmable logic device (CPLD), programmable gate array (PGA), structured application specific ICs (structured ASICs), and field programmable gate array (FPGA).

Referring to the figures, persons of ordinary skill in the art will note that the various blocks shown may depict mainly the conceptual functions and signal flow. The actual circuit implementation may or may not contain separately identifiable hardware for the various functional blocks and may or may not use the particular circuitry shown. For example, one may combine the functionality of various blocks into one circuit block, as desired. Furthermore, one may realize the functionality of a single block in several circuit blocks, as desired. The choice of circuit implementation depends on various factors, such as particular design and performance specifications for a given implementation, as persons of ordinary skill in the art who have the benefit of the description of the invention understand. Other modifications and alternative embodiments of the invention in addition to those described here will be apparent to persons of ordinary skill in the art who have the benefit of the description of the invention. Accordingly, this description teaches those skilled in the art the manner of carrying out the invention and are to be construed as illustrative only.

The forms of the invention shown and described should be taken as the presently preferred or illustrative embodiments. Persons skilled in the art may make various changes in the shape, size and arrangement of parts without departing from the scope of the invention described in this document. For example, persons skilled in the art may substitute equivalent elements for the elements illustrated and described here. Moreover, persons skilled in the art who have the benefit of this description of the invention may use certain features of the invention independently of the use of other features, without departing from the scope of the invention.

**Claims**

1. An interconnect circuit, comprising:

   a driver circuit configured to derive from an input signal a limited swing driver output signal; and
   a receiver circuit coupled to the driver circuit, the receiver circuit configured to derive from the limited swing driver output signal a limited swing receiver output signal.

2. The interconnect circuit according to claim 1, wherein the limited swing driver output signal has a first signal state corresponding to the limited swing driver output signal having a potential more than a ground potential, and a second signal state corresponding to the limited voltage swing driver output signal having a potential less than a supply voltage.

3. The interconnect circuit according to claim 1, wherein the limited swing receiver output signal has a first signal state corresponding to the limited swing receiver output signal having a potential more than a ground potential, and a second signal state corresponding to the limited voltage swing receiver output signal having a potential less than a supply voltage.

4. The interconnect circuit according to claim 1, wherein the input signal is supplied by a first programmable logic circuit within a programmable logic device (PLD).

5. The interconnect circuit according to claim 1, further comprising:

   a pre-driver circuit; and
   a level converter circuit coupled to the pre-driver circuit.

6. The interconnect circuit according to claim 5, wherein the level converter circuit comprises a PMOS transistor coupled to an NMOS transistor.

7. The interconnect circuit according to claim 5, wherein the pre-driver circuit further comprises a cascade coupling of a plurality of transistors, wherein a first transistor in the plurality of transistors has a higher than nominal threshold voltage.

8. The interconnect circuit according to claim 7, wherein the pre-driver circuit further comprises a second transistor coupled to the first transistor, and a third transistor coupled to the first transistor and to a ground potential.

9. The interconnect circuit according to claim 5, wherein the pre-driver circuit further comprises a PMOS transistor coupled to an NMOS transistor, wherein the PMOS transistor is driven by a first signal and the NMOS transistor is driven by a second signal, and wherein the first and second signals comprise complementary signals.

**10.** The interconnect circuit according to claim 5, wherein the pre-driver circuit further comprises:

a PMOS transistor driven by a feedback signal derived from the driver output signal; and
an NMOS transistor driven by the feedback signal derived from the driver output signal.

**11.** The interconnect circuit according to claim 5, wherein the pre-driver circuit further comprises:

a PMOS transistor, having a higher than nominal threshold voltage; and
an NMOS transistor, having a higher than nominal threshold voltage, coupled to the PMOS transistor.

**12.** An interconnect circuit for coupling resources in a programmable logic device (PLD), the interconnect circuit comprising a driver circuit that includes at least one transistor having a threshold voltage higher than a nominal threshold voltage.

**13.** The interconnect circuit according to claim 12, wherein the driver circuit comprises a pre-driver circuit coupled to a level converter circuit.

**14.** The interconnect circuit according to claim 12, further comprising a receiver circuit that includes at least one transistor having a threshold voltage higher than the nominal threshold voltage.

**15.** The interconnect circuit according to claim 14, wherein the driver circuit derives a limited swing driver output signal from an input signal.

**16.** The interconnect circuit according to claim 15, wherein the limited swing driver output signal has a first signal state with a voltage higher than a ground voltage, and a second signal state with a voltage lower than a supply voltage.

**17.** The interconnect circuit according to claim 14, wherein the receiver circuit derives a limited swing receiver output signal from the limited swing driver output signal.

**18.** The interconnect circuit according to claim 17, wherein the limited swing receiver output signal has a first signal state with a voltage higher than a ground voltage, and a second signal state with a voltage lower than a supply voltage.

**19.** The interconnect circuit according to claim 13, wherein the level converter circuit comprises a PMOS transistor coupled to an NMOS transistor.

**20.** The interconnect circuit according to claim 12, wherein the driver circuit further comprises a cascade coupling of a plurality of transistors, wherein a first transistor in the plurality of transistors has a higher than the nominal threshold voltage.

**21.** The interconnect circuit according to claim 20, wherein the driver circuit further comprises a second transistor coupled to the first transistor, and a third transistor coupled to the first transistor and to a ground potential.

**22.** The interconnect circuit according to claim 12, wherein the driver circuit further comprises a PMOS transistor coupled to an NMOS transistor, wherein the PMOS transistor is driven by a first signal and the NMOS transistor is driven by a second signal, and wherein the first and second signals comprise complementary signals.

**23.** The interconnect circuit according to claim 12, wherein the driver circuit further comprises:

a PMOS transistor driven by a feedback signal derived from the driver output signal; and
an NMOS transistor driven by the feedback signal derived from the driver output signal.

**24.** The interconnect circuit according to claim 12, wherein the driver circuit further comprises:

a PMOS transistor, having a higher than the nominal threshold voltage; and
an NMOS transistor, having a higher than the nominal threshold voltage, coupled to the PMOS transistor.

25. The interconnect according to claim 14, wherein the driver circuit couples to a first programmable logic circuit within the PLD, and the receiver circuit couples to a second programmable logic circuit within the PLD.

26. A method of interconnecting circuitry within a programmable logic device (PLD), the method comprising:

receiving in a first circuit an input signal from a source;
generating an output signal of the first circuit, wherein the output signal of the first circuit has a limited swing;
supplying the output signal of the first circuit to a second circuit; and
generating an output signal of the second circuit, wherein the output signal of the second circuit has a limited swing.

27. The method according to claim 26, wherein receiving the input signal further comprises receiving the input signal from a first programmable logic circuit in the PLD.

28. The method according to claim 27, further comprising supplying the output signal of the second circuit to a second programmable logic circuit within the PLD.

29. The method according to claim 26, wherein the first circuit comprises at least one transistor having a threshold voltage that differs from a nominal threshold voltage.

30. The method according to claim 26, wherein the second circuit comprises at least one transistor having a threshold voltage that differs from a nominal threshold voltage.

31. The method according to claim 26, wherein the first circuit comprises a driver circuit.

32. The method according to claim 31, wherein the second circuit comprises a receiver circuit.

33. The method according to claim 26, supplying the output signal of the first circuit to the second circuit further comprises routing the output signal of the first circuit through a plurality of transistors.

34. The method according to claim 26, wherein the output signal of the first circuit has a first state corresponding to a voltage level different from a ground voltage, and a second state corresponding to a voltage level different from a supply voltage.

35. The method according to claim 26, wherein the output signal of the second circuit has a first state corresponding to a voltage level different from a ground voltage, and a second state corresponding to a voltage level different from a supply voltage.

FIG. 1

FIG. 2

FIG. 3

FIG. 4

FIG. 5

EP 1 744 459 A2

Input ——□ 260A □ 263A —— □ 109A —— □ 260B □ 263B —— Output

255

203

205

109

FIG. 6

FIG. 7

FIG. 8

FIG. 9

FIG. 10

FIG. 11

EP 1 744 459 A2

FIG. 12

FIG. 13

EP 1 744 459 A2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 69822505 P